Europäisches Patentamt

European Patent Office

Office européen des brevets

(11) Veröffentlichungsnummer: **0 433 476 A1**

## EUROPÄISCHE PATENTANMELDUNG

(21) Anmeldenummer: **89123497.3**

(22) Anmeldetag: **19.12.89**

(51) Int. Cl.⁵: **H01L 29/08**, H01L 29/743, H01L 29/74

(43) Veröffentlichungstag der Anmeldung:
**26.06.91 Patentblatt 91/26**

(84) Benannte Vertragsstaaten:
**CH DE FR GB IT LI**

(71) Anmelder: **EUPEC Europäische Gesellschaft für Leistungshalbleiter mbH & Co. KG**
**Max-Planck-Strasse 5**
**W-4788 Warstein/Belecke(DE)**

(72) Erfinder: **Voss, Peter, Dr.**
**Rudliebstrasse 42**
**W-8000 München 81(DE)**

(74) Vertreter: **Fuchs, Franz-Josef, Dr.-Ing. et al**
**Postfach 22 13 17**
**W-8000 München 22(DE)**

(54) **Thyristor mit Katodenkurzschlüssen.**

(57) Zur Verbesserung der dynamischen Eigenschaften von Thyristoren kann es erwünscht sein, die Speicherladung in Emitternähe abzusenken. Dies kann dadurch erreicht werden, daß der Emitterwirkungsgrad bei hoher Stromdichte durch Kurzschlüsse verschlechtert wird. Katodenseitig sind die Kurzschlüsse derart aufgebaut, daß in der Emitterzone hochdotierte Kurzschlußgebiete (4) angeordnet sind. Die Kurzschlußgebiete (4) werden von Zwischengebieten (5) überlappt, die den gleichen Leitungstyp wie die Emitterzone haben. Die nicht überlappte Fläche ist wesentlich kleiner als die Fläche der Kurzschlußgebiete (4). Damit ist bei geringer Stromdichte die kurzschließende Fläche klein, bei hoher Stromdichte groß. Ähnliche Kurzschlüsse sind auch anodenseitig anwendbar.

FIG 1

# THYRISTOR MIT KATODENKURZSCHLÜSSEN

Die Erfindung bezieht sich auf einen Thyristor mit einem Halbleiterkörper mit mindestens einer an die katodenseitige Oberfläche grenzenden Emitterzone vom ersten Leitungstyp, mit einer katodenseitigen Basiszone vom zweiten Leitungstyp und mit einer die Basiszone und die Emitterzone kurzschließenden Katodenelektrode.

Thyristoren dieser Art sind Stand der Technik. Die Kurzschlüsse sind bei solchen Thyristoren im allgemeinen auf der Katodenseite angeordnet. Damit wird der Wirkungsgrad des katodenseitigen Emitters reduziert. Die Kurzschlüsse nehmen im allgemeinen eine gemessen an der Thyristorfläche kleine Fläche ein, um den Zündstrom niedrig zu halten und um die Ausbreitung des Zündvorgangs sicherzustellen. Diese kleinflächigen Kurzschlüsse machen sich bei höherer Stromdichte im vollständig von Ladungsträgern überschwemmten Zustand praktisch nicht mehr bemerkbar.

Im Hinblick auf günstige dynamische Eigenschaften des Thyristors in manchen Anwendungsfällen, z. B. bei Stromrichtern und Choppern kann es wünschenswert sein, den Emitterwirkungsgrad auf der Katodenseite oder auf der Katoden- und Anodenseite bis in den Bereich hoher Stromdichte herabzusetzen. Dies bedeutet relativ großflächige Kurzschlußbereiche, die sich im Bereich niedriger Stromdichte z. B. für die Zündausbreitung nachteilig auswirken würden.

Ziel der Erfindung ist es, einen Thyristor der erwähnten Gattung mit Kurzschlüssen zwischen der katodenseitigen Basiszone und der katodenseitigen Emitterzone derart weiterzubilden, daß die Kurzschlüsse bei niedriger Stromdichte die Zündausbreitung nicht behindern und bei hoher Stromdichte die dynamischen Eigenschaften des Thyristors günstig beeinflussen.

Dieses Ziel wird erreicht durch die Merkmale:
a) In der Emitterzone sind Kurzschlußgebiete vom zweiten Leitungs typ angeordnet, die an die Oberfläche des Halbleiterkörpers angrenzen und eine höhere Dotierungskonzentration als die Basiszone haben,
b) zwischen der Basiszone und der Emitterzone ist mindestens eine Zwischenzone des ersten Leitungstyps angeordnet, die eine niedrigere Dotierung als die Emitterzone und eine höhere Dotierung als die Basiszone hat,
c) die Zwischenzone hat eine größere Fläche als die Emitterzone und überlappt jedes der Kurzschlußgebiete,
d) die von der Zwischenzone nicht überlappte Fläche jedes der Kurzschlußgebiete ist wesentlich kleiner als die Fläche dieser Kurzschlußgebiete.

Weiterbildungen der Erfindung sind Gegenstand der Unteransprüche.

Die Erfindung wird anhand eines Ausführungsbeispiels in Verbindung mit den FIG 1 bis 3 näher erläutert. Es zeigen

FIG 1 einen Schnitt durch einen Thyristor gemäß der Erfindung mit dem Stromverlauf bei niedriger Stromdichte,

FIG 2 einen möglichen Dotierungsverlauf der verschiedenen Zonen des Thyristors und

FIG 3 den Thyristor nach FIG 1 mit dem Stromverlauf bei hoher Stromdichte.

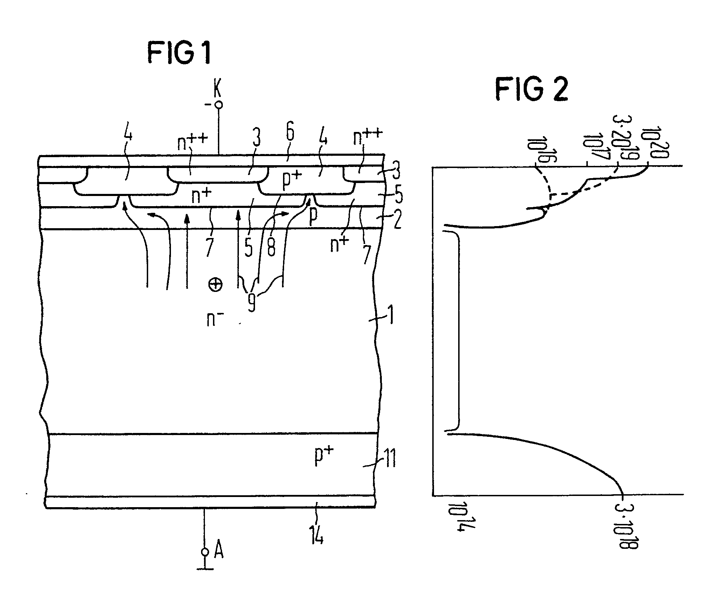

Der Thyristor nach FIG 1 hat eine schwach n-dotierte Mittelzone 1 und eine stärker p-dotierte katodenseitige Basiszone 2. In die Basiszone 2 ist eine stark n-dotierte Emitterzone 3 eingebettet. Die Emitterzone 3 hat Aussparungen, in denen stark p-dotierte Kurzschlußgebiete 4 angeordnet sind. Diese Kurzschlußgebiete können etwa gleiche Tiefe wie die Emitterzone 3 haben, sie können aber auch dicker ausgebildet sein. Zwischen der Basiszone 2 und der Emitterzone 3 ist eine n-dotierte Zwischenzone 5 angeordnet. Diese Zwischenzone hat eine höhere Dotierung als die Basiszone 2, jedoch niedrigere Dotierung als die Emitterzone 3. Zwischen den Kurzschlußgebieten 4 und der Zwischenzonen 5 liegen pn-Übergänge 8.

Die Zwischenzone 5 überlappt die Kurzschlußgebiete 4 derart, daß die nicht überlappte Fläche der Kurzschlußgebiete 4 klein gegenüber der gesamten Fläche der Kurzschlußgebiete ist. Die Zwischenzone 5 kann eine Fläche von mindestens 90 % der Katodenfläche des Thyristors, z. B. 98 % einnehmen. Die Fläche der Kurzschlußgebiete 4 kann eine Fläche zwischen 10 und 70 % der katodenseitigen Fläche des Thyristors haben. Die Emitterzone 3 und die Kurzschlußgebiete 4 sind gemeinsam durch eine Katodenelektrode 6 kontaktiert.

Die Randdotierung der Zonen 3, 4, 5 und 2 kann beispielsweise $10^{20}$, $3 \times 10^{18}$, $10^{17}$ und $10^{16}$ betragen (FIG 2). Eine Zonenfolge mit inverser Dotierung ist möglich.

In FIG 1 ist der Weg der positiven Ladungsträger bei gegenüber der Anode negativer Katode für kleine Stromdichte eingezeichnet. Aus der $n^+$-Zone 5 werden Elektronen emittiert, sobald die Querspannung unter dieser Zone ca. 0,5 V erreicht. Da die von der Zwischenzone 5 nicht überlappte Fläche der Kurzschlußgebiete 4 wie oben erwähnt klein ist, ist die Kurzschlußwirkung gering und dementsprechend stellt sich ein niedriger Wert für den Zündstrom ein. Außerdem wird die Plasmaausbreitung wenig behindert. Auf der anderen Seite ist die Kurzschlußwirkung kräftig genug, um ein du/dt-Zünden zu verhindern.

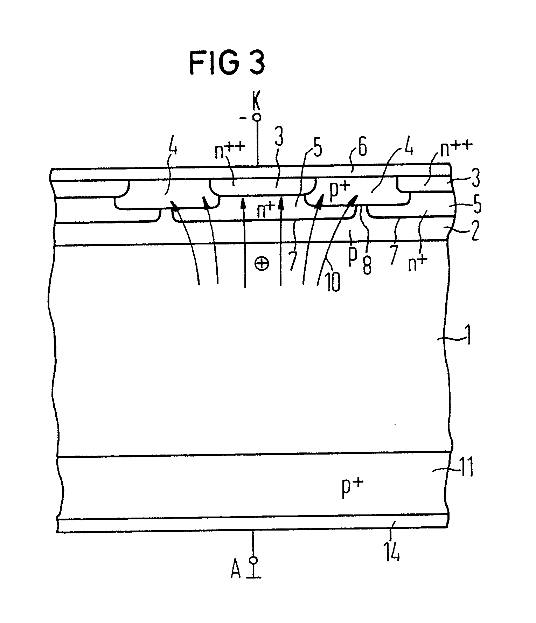

Bei hoher Stromdichte nehmen die positiven Ladungsträger einen Weg, der in FIG 3 durch die Pfeile 10 symbolisiert ist. Hierbei werden auch die pn-Übergänge 8 zwischen den Kurzschlußgebieten 4 und der Zwischenzone 5 von Ladungsträgern überschwemmt. Daher kann jetzt ein großer Teil der positiven Ladungsträger durch die überlappende Fläche der Zwischenzone 5 zu den Kurzschlußgebieten 4 abfließen. Die kurzschließende Fläche ist in diesem Fall daher entsprechend der oben angegebenen Dimensionen für die Fläche der Kurzschlußgebiete auf 10 bis 70 % der Katodenfläche des Thyristors angewachsen.

Mit dieser Maßnahme läßt sich die katodenseitige Speicherladung wesentlich absenken, so daß im Abschaltfall von vornherein in der Nähe des Blockier-pn-Überganges nur wenig Ladungsträger vorhanden sind. Gegenüber den beschriebenen katodenseitigen Kurzschlüssen leicht abgewandelte Kurzschlüsse lassen sich auch auf der Anodenseite des Thyristors anordnen. Solche anodenseitigen Kurzschlüsse sind bereits Gegenstand der älteren Anmeldung P 39 39 324.0. Mit den zusätzlichen anodenseitigen Kurzschlüssen läßt sich auch die anodenseitige Speicherladung reduzieren.

Die Erfindung wurde anhand eines Ausführungsbeispiels beschrieben, bei dem eine einzige katodenseitige bzw. anodenseitige Emitterzone, mehrere Kurzschlußgebiete und je eine einzige Zwischenzone vorgesehen ist. Es können jedoch auch viele Emitterzonen, z. B. in der Form von Streifen, vorgesehen sein. Dann ist jeweils nur ein einziges zusammenhängendes Kurzschlußgebiet vorhanden. Die Zwischenzone ist dann entsprechend der Emitterzonen ebenfalls in der Form einer Vielzahl von Streifen ausgebildet.

**Ansprüche**

1. Thyristor mit einem Halbleiterkörper mit mindestens einer an die katodenseitige Oberfläche grenzenden Emitterzone vom ersten Leitungstyp, mit einer katodenseitigen Basiszone vom zweiten Leitungstyp und mit einer die Basiszone und die Emitterzone kurzschließenden Katodenelektrode, **gekennzeichnet durch** die Merkmale:

a) in der Emitterzone (3) sind Kurzschlußgebiete (4) vom zweiten Leitungstyp angeordnet, die an die Oberfläche des Halbleiterkörpers angrenzen und eine höhere Dotierungskonzentration als die Basiszone (2) haben,

b) zwischen der Basiszone und der Emitterzone ist mindestens eine Zwischenzone (5) des ersten Leitungstyps angeordnet, die eine niedrigere Dotierung als die Emitterzone und eine höhere Dotierung als die Basiszone hat,

c) die Zwischenzone (5) hat eine größere Fläche als die Emitterzone (3) und überlappt jedes der Kurzschlußgebiete (4),

d) die von der Zwischenzone nicht überlappte Fläche jedes der Kurzschlußgebiete ist wesentlich kleiner als die Fläche dieser Kurzschlußgebiete.

2. Thyristor nach Anspruch 1, **dadurch gekennzeichnet,** daß die Kurzschlußgebiete (4) eine größere Dicke als die Emitterzone (3) haben.

# FIG 1

# FIG 2

4

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 5, Nr. 163 (E-78)[835], 20. Oktober 1981; & JP-A-56 91 469 (HITACHI SEISAKUSHO K.K.) 24-07-1981 * Zusammenfassung; Figuren * --- | 1,2 | H 01 L 29/08 H 01 L 29/743 H 01 L 29/74 |
| A | PATENT ABSTRACTS OF JAPAN, Band 7, Nr. 58 (E-163)[1203], 10. März 1983; & JP-A-57 206 072 (HITACHI SEISAKUSHO K.K.) 17-12-1982 * Zusammenfassung; Figuren * ----- | 1 | |
| | | | **RECHERCHIERTE SACHGEBIETE (Int. Cl.5)** H 01 L |

Der vorliegende Recherchenbericht wurde für alle Patentansprüche erstellt

| Recherchenort | Abschlußdatum der Recherche | Prüfer |
|---|---|---|
| DEN HAAG | 19-08-1990 | MORVAN D.L.D. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
··········································
& : Mitglied der gleichen Patentfamilie, übereinstimmendes Dokument